# EUROPEAN PATENT APPLICATION

(11) **EP 2 184 781 A1**
(43) Date of publication of application: **12.05.2010**
(21) Application number: 08168332.8
(22) Date of filing: 05.11.2008
(51) Int. Cl.: H01L 29/08, H01L 29/739, H01L 21/331

(54) **Reverse-conducting semiconductor device**

(71) Applicant: ABB Technology AG, 8050 Zürich (CH)
(72) Inventor: Rahimo, Munaf, 5619 Uezwil (CH); Kopta, Arnost, 8045 Zürich (CH)
(74) Representative: ABB Patent Attorneys

(57) **Abstract**

A reverse-conducting semiconductor device (200) is provided, which comprises a freewheeling diode and an insulated gate bipolar transistor on a common wafer (100), part of which wafer (100) forms a base layer (101) with a base layer width (102). The insulated gate bipolar transistor comprises a collector side (103) and an emitter side (104), whereas the collector side (103) is arranged opposite of the emitter side (104) of the wafer (100). A first layer (1) of a first conductivity type and a second layer (2) of a second conductivity type are alternately arranged on the collector side (103). The first layer (1) comprises at least one first region (10) with a first region width (11) and at least one second region (12) with a second region width (13). The second layer (2) comprises at least one third (20) region with a third region width (21) and at least one fourth region (22) with a fourth region width (23).

The RC-IGBT is designed in such a way that the following geometrical rules are fulfilled:
Each third region width (21) is the equal to or larger than the base layer width (102), whereas each first region width (11) is smaller than the base layer width (102).
Each fourth region width (23) is larger than each second region width (13).
Each second region width is the equal to or larger than two times the base layer width (102) and the total area of the fourth regions (22) is larger than the total area of the second regions (12).

## Description

### Technical Field

The invention relates to the field of power electronics and more particularly to a reverse-conducting semiconductor device according to the preamble of claim 1 and to a converter with such a reverse-conducting semiconductor device according to claim 13.

### Background Art

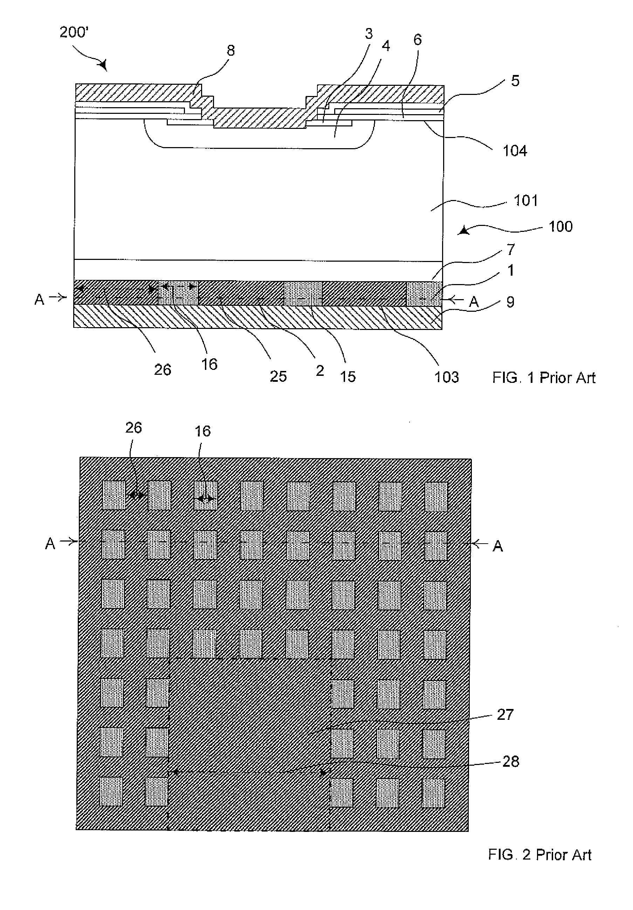

In US 2008/0135871 A1 a reverse-conducting semiconductor device 200', reverse-conducting insulated gate bipolar transistor (RC-IGBT) as shown in FIG 1 is described, which comprises within one wafer 100 an insulated gate bipolar transistor with a built-in freewheeling diode. As shown in Fig. 1, such a reverse-conducting semiconductor device200' comprises an n type base layer layer 101 with a first main side, which is the emitter side 104 of the integrated IGBT, and a second main side, which is the collector side 103 of the IGBT and which lies opposite the emitter side 104. A fourth p type layer 4 is arranged on the emitter side 104. On the fourth layer 4 third n type layers 3 with a higher doping than the base layer 101 are arranged.

A sixth electrically insulating layer 6 is arranged on the emitter side 104 and covers the fourth layer 4 and the base layer 101 and partially covers the third layer 3. An electrically conductive fifth layer 5 is completely embedded in the sixth layer 6. Above the central part of the fourth layer 4 no third or sixth layer 3, 6 is arranged.

On this central part of the fourth layer 4, a first electrical contact 8 is arranged, which also covers the sixth layer 6. The first electrical contact 8 is in direct electrical contact to the third layer 3 and the fourth layer 4, but is electrically insulated from the fifth layer 5.

On the second main side, a seventh layer 7 formed as a buffer layer is arranged on the base layer 101. On the seventh layer 7, n type first layers 1 and p type second layers 2 are arranged alternately in a plane. The first layers 1 as well as the seventh layer 7 have a higher doping than the base layer 101.

A second electrical contact 9 is arranged on the collector side 103 and it covers the first and second layers 1, 2 and is in direct electrical contact to them.

In such a reverse-conducting semiconductor device 200' a freewheeling diode is formed between the second electrical contact 9, part of which forms a cathode electrode in the diode, the n type first layer 1, which forms a cathode region in the diode, the base layer 101, part of which forms the diode base layer, the p type fourth layer 4, part of which forms an anode region in the diode and the first electrical contact 8, which forms an anode in the diode.

An insulated gate bipolar transistor (IGBT) is formed between the second electrical contact 9, part of which forms the collector electrode in the IGBT, the p type second layer 2, which forms a collector region in the IGBT, the base layer 101, part of which forms the IGBT base layer, the fourth layer 4, part of which forms a p-base region in the IGBT, the third layer 3, which forms a n type source region in the IGBT, and the first electrical contact 8, which forms an emitter electrode. During on-state of the IGBT a channel is formed between the emitter electrode, the source region and the p-base region towards the n-base layer.

The n type first layer 1 comprises a plurality of fifth regions 15 with a fifth region width 16. The p type second layer 2 comprises a plurality of sixth region 25 with a sixth region width 26. The second layer 2 forms a continuous layer, in which each fifth region 15 is surrounded by the continuous second layer 2.

In FIG 2 the first and second layer 1, 2 are shown over the whole wafer area through a cut along the line A - A from FIG 1. This line is also indicated in FIG 2 in order to show that the RC-IGBT 200' does not have the same structure for the first and second layer 1, 2 over the whole plane of the wafer 100. In the upper part of the figure (see line A - A) the structure of regularly arranged fifth regions 15 and sixth regions 25 is shown.

In the lower part of FIG 2, it is shown that the second layer 2 further comprises a seventh region 27 (surrounded by a dashed line in the figure), which has a larger seventh region width 28, which is larger than the width 26 of any sixth region 25. The width 28 of a seventh region 27 plus the width 16 of a fifth region 15 is 1.5 to 5 times larger than the width 26 of a sixth region 25 plus the width 16 of a fifth region 15.

Such a structure is used in order to get large p doped areas for improvement of the on-state properties of the semiconductor device and by having areas, in which the p doped regions in form of sixth regions 25 are small compared to the seventh regions 27, the distance between the fifth regions 15 in the areas, in which fifth regions 15 are present, can be kept small. Thereby, the device can be used for higher currents.

However, due to the usage of fifth regions 15, each of which is surrounded by sixth regions 25, the possibilities to achieve good diode properties of the RC-IGBT are strongly limited, because the area of the n type first layer 1, which is responsible for the diode properties, is small due to the geometrical conditions of such a prior art device as known from US 2008/0135871 A1. If, e.g. the width 16 of the fifth regions 15 is made as large as that of the sixth regions 25, the total n doped area is already not more than 25 % of the whole area. By additionally introducing further large p area as p doped seventh regions 27, the total n doped area is further reduced. If on the other hand, the width 16 of the fifth regions 15 compared to the sixth regions 25 was enlarged, the IGBT properties would be worsened in an unacceptable manner, because snap back effects could occur.

### Disclosure of Invention

It is an object of the invention to provide a reverse-conducting semiconductor device with improved diode performance without sacrificing the IGBT performance.

This object is achieved by a reverse-conducting semiconductor device according to claim 1 and by a converter according to claim 13.

The inventive reverse-conducting insulated gate bipolar transistor (RC-IGBT) comprises a freewheeling diode and an insulated gate bipolar transistor (IGBT) on a common wafer, part of which wafer forms a base layer with a base layer width. The insulated gate bipolar transistor comprises a collector side and an emitter side, whereas the collector side is arranged opposite of the emitter side of the wafer. A first layer of a first conductivity type and a second layer of a second conductivity type are alternately arranged on the collector side. The first layer comprises at least one first and at least one second region, wherein each first region has a first region width and each second region has a second region width. The second layer comprises at least one third and at least one fourth region, wherein each third region has a third region width and each fourth region has a fourth region width. The following geometrical rules have to be fulfilled:
- each third region width is the equal to or larger than the base layer thickness,
- each first region width is smaller than the base layer thickness,
- each fourth region width is larger than each second region width,
- each second region width is the equal to or larger than two times the base layer thickness, and
- the total area of the fourth regions is larger than the total area of the second regions.

The conditions ensure that small first regions are present compared to the second regions so that the IGBT area is kept large and snap back effects, which occur at large first diode regions, are avoided.

Since the small first and third regions do not heavily influence the IGBT mode in line with the above design rule, their dimensions are adjusted to achieve the required diode area.

By the introduction of separate third and fourth regions with much increased dimensions compared to the first and second regions, regions are created which are either dedicated as IGBT regions or diode regions not operating in the opposite mode.

By introducing only a few of the third and fourth regions compared to the first and second regions, large areas of the device with shorted structures (first and second regions) are maintained.

In order not to sacrifice too much IGBT area, the p-type fourth regions as pilot regions ensure increased IGBT area while at the same time second regions as pilot n-type regions ensure a reasonably large diode area.

The first and third regions form the main shorted region in which the silicon area included is utilized in both IGBT and diode mode. These regions also influence the main IGBT electrical properties. The second and forth regions are mainly present to give more freedom to determine the IGBT to diode area ratio and decouple this design aspect from the standard approach involving the first and second regions only. By introducing the second regions, larger dimensions can be chosen for the third regions which will result in two positive features. First the elimination of snap-back during the on-state characteristics of the IGBT. Secondly, softer turn-off performance for both the IGBT and diode.

Further preferred embodiments of the inventive subject matter are disclosed in the dependent claims.

### Brief Description of Drawings

The subject matter of the invention will be explained in more detail in the following text with reference to the attached drawings, in which:
- FIG 1: shows a cross sectional view on a prior art reverse-conducting IGBT;
- FIG 2: shows a plan view of the structures of the first and second layers of a prior art RC-IGBT;
- FIG 3: shows a cross sectional view on an inventive reverse-conducting IGBT;
- FIG 4: shows a plan view of the structures of first and third regions of a reverse-conducting IGBT according to the invention;
- FIG 5: shows a plan view of the structures of first and third regions of another reverse-conducting IGBT according to the invention;
- FIG 6: shows a plan view of the structures of first layers with first and second regions and second layers with third and fourth regions of another reverse-conducting IGBT according to the invention;
- FIG 7: shows a plan view of the structures of first layers with first and second regions and second layers with third and fourth regions of another reverse-conducting IGBT according to the invention;
- FIG 8: shows a plan view of the structures of first layers with first and second regions and second layers with third and fourth regions of another reverse-conducting IGBT according to the invention;
- FIG 9: shows the layers on the emitter side of another inventive reverse-conducting IGBT with trench gate electrodes; and
- FIG 10: shows the layers on the emitter side of another inventive reverse-conducting IGBT with an enhancement layer.

The reference symbols used in the figures and their meaning are summarized in the list of reference symbols. Generally, alike or alike-functioning parts are given the same reference symbols. The described embodiments are meant as examples and shall not confine the invention.

### Modes for Carrying out the Invention

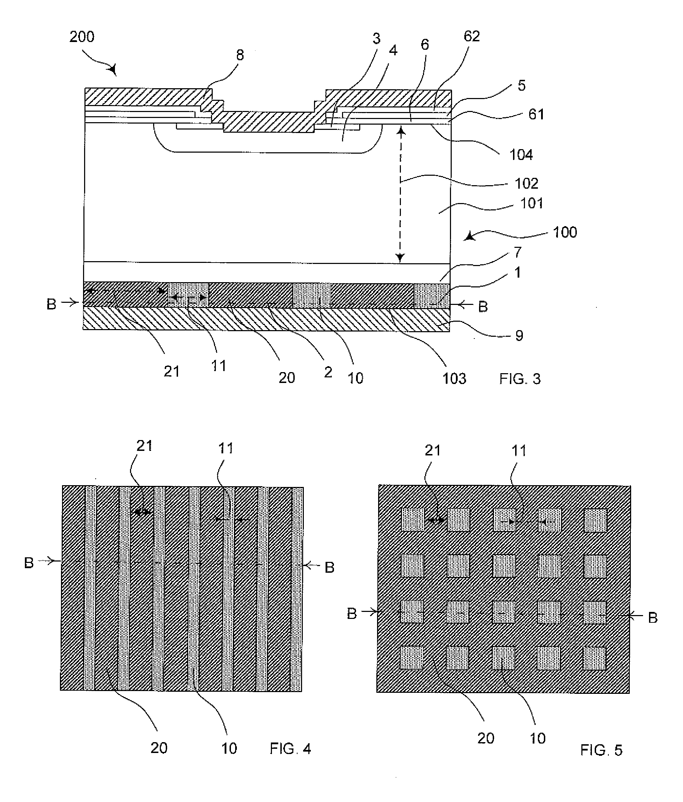

In Fig. 3 a first embodiment of an inventive reverse-conducting semiconductor device 200, also named reverse-conducting insulated gate bipolar transistor (RC-IGBT) is shown. The RC-IGBT 200 comprises an n type base layer 101 with a first main side, which forms the emitter side 104 of the integrated IGBT, and a second main side opposite the first main side, which forms the collector side 103 of the integrated IGBT. The base layer 101 has a base layer width 102. The base layer 101 is that part of a wafer 100, which has an un-amended doping in the finalized reverse-conducting insulated gate bipolar transistor.

A p type fourth layer 4 is arranged on the emitter side 104. At least one n type third layer 3 is also arranged on the emitter side 104 and it is surrounded by the fourth layer 4. The at least one third layer 3 has a higher doping than the base layer 101. A sixth electrically insulating layer 6 is arranged on the emitter side 104 on top of the base layer 101, the fourth and third layer 4, 3. It at least partially covers the at least one third layer 3, the fourth layer 4 and the base layer 101. An electrically conductive fifth layer 5 is arranged on the emitter side 104 electrically insulated from the at least one fourth layer 4, the third layer 3 and the base layer 101 by the sixth layer 6. Preferably, the fifth layer 5 is embedded in the sixth layer 6.

Typically the sixth layer 6 comprises a first electrically insulating layer 61, preferably made of a silicon dioxide, and a second electrically insulating layer 62, preferably also made of a silicon dioxide, preferably of the same material as the first electrically insulating layer 61. The second electrically insulating layer 62 covers the first electrically insulating layer 61. For an RC-IGBT 200 with a fifth layer 5 formed as a planar gate electrode as shown is Fig. 3 the first electrically insulating layer 61 is arranged on top of the emitter side 104. In between the first and second electrically insulating layers 61, 62, which form the sixth layer 6, the fifth layer 5, which forms a gate electrode, is embedded, typically it is completely embedded. Thus, the fifth layer 5 is separated from the base layer 101, the fourth and third layer 4, 3 by the first electrically insulated layer 61. The fifth layer 5 is typically made of a heavily doped polysilicon or a metal like aluminum.

The at least one third layer 3, the fifth layer 5 and the sixth layer 6 are formed in such a way that an opening is created above the fourth layer 4. The opening is surrounded by the at least one third layer 3, the fifth layer 5 and the sixth layer 6.

A first electrical contact 8 is arranged on the emitter side 104 within the opening so that it is in direct electrical contact to the fourth layer 4 and the third layer 3. This first electrical contact 8 typically also covers the sixth layer 6, but is separated and thus electrically insulated from the fifth layer 5 by the second electrically insulating layer 62.

An n type first layer 1 and an p type second layer 2 are arranged on the collector side 103 and the first layer 1 has a higher doping than the base layer 101. The first and second layers 1, 2 can be arranged in the same plane or, alternatively, they can also be arranged in different planes, whereas the planes from the first and second layer 1, 2 are spaced from each other at least by the thickness of that layer, which is arranged farer away from the collector side 103. Devices with such first and second layers 1, 2 being arranged in different planes and their manufacturing methods are known from the European patent applications with filing numbers EP 07150162 and EP 07150165.

A second electrical contact 9 is arranged on the collector side 103 and it is in direct electrical contact to the at least one first and second layers 1, 2. Typically, Ti, Ni, Au or Al are used as a material for the second electrical contact 9.

In the inventive RC-IGBT 200 a diode is formed between the first electrical contact 8, which forms an anode electrode in the diode, the fourth layer 4, part of which forms an anode layer, the base layer 101, part of which forms a base layer for the diode, the n type first layer 1 and which layer forms a cathode layer, and the second electrical contact 9, which forms a cathode electrode.

In the inventive RC-IGBT 200 an insulated gate bipolar transistor (IGBT) is formed between the first electrical contact 8, which forms an emitter electrode in the IGBT, the third layer 3, which forms a source region, the fourth layer 4, part of which forms a channel region, the base layer 101, part of which forms a base region for the IGBT, the p type second layer 2, which forms a collector layer and the second electrical contact 9, part of which forms a collector electrode.

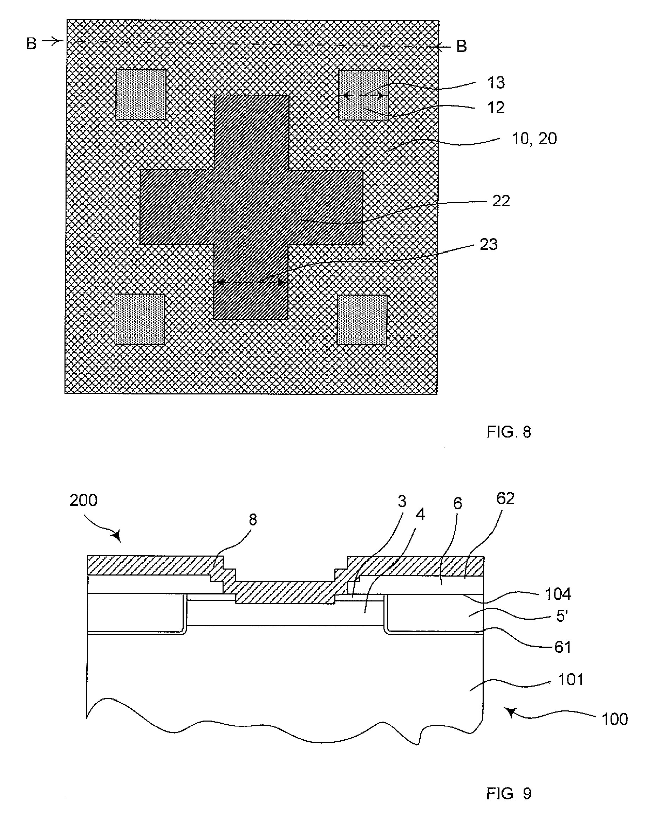

Alternatively to the inventive RC-IGBT with a planar gate electrode, the inventive RC-IGBT may comprise a fifth layer 5', formed as trench gate electrode as shown in FIG 9. The trench gate electrode is arranged in the same plane as the fourth layer 4 and adjacent to the third layer 3, separated from each other by a first insulating layer 61, which also separates the fifth layer 5' from the base layer 101. A second insulating layer 62 is arranged on top of the fifth layer 5' formed as a trench gate electrode, thus insulating the fifth layer 5' from the first electrical contact 8.

The n type first layer 1 comprises at least one first and at least one second region 10, 12, wherein each first region 10 has a first region width 11 and each second region 12 has a second region width 13. Typically the first layer 1 comprises a plurality of first regions 10 and/or second regions 12.

The p type second layer 2 comprises at least one third 20 and at least one fourth region 22, wherein each third region 20 has a third region width 21 and each fourth region 22 has a fourth region width 23. Typically the second layer 2 comprises a plurality of third regions 20 and/or fourth regions 22.

The third regions 20 and the first regions 10 form shorted regions. Each third region width 21 is the equal to or larger than the base layer width 102 and each first region width 11 is smaller than the base layer width 102.

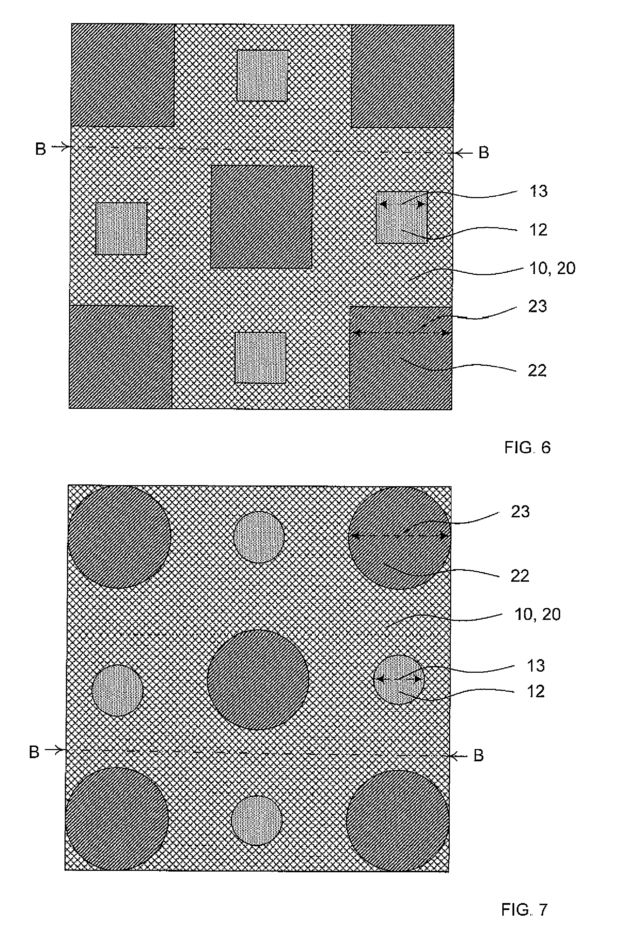

FIG 4 shows a cut through the first and second layer 1, 2 along the line B - B from FIG 3. This line is also indicated in FIG 4 in order to show that the RC-IGBT does not have the same structure for the first and second layer 1, 2 over the whole plane of the wafer 100. There are parts in which the first and second layer 1, 2 only comprises first and third regions 10, 20 as shown in FIG 4 and 5 and which are also present in the FIG 6, 7 and 8 e.g. along the line B - B. In other parts of the RC-IGBT 200, the first and second layer 1, 2 comprise fourth regions 22 and second regions 12, which form pilot regions. The width 23 of each fourth region 22 is larger than each second region width 13. Each second region width 13 is the equal to or larger than two times the base layer width 102. Furthermore, the total area of the fourth regions 22 is larger than the total area of the second regions 12.

In another preferred embodiment the total area of the third and fourth regions 20, 22 to total area of the wafer 100 is between 70 % up to 90 %. In such a device the total area of the first and second regions 10, 12 to total area of the wafer 100 is between 10 % up to 30 %.

In a further preferred embodiment the total area of the forth regions 22 to the total area of the wafer 100 is between 10 % to 30 %.

The widths 11, 21 of the shorted first and/or third regions 10, 20 can be constant over the whole wafer area so that the first and third regions 10, 20 are arranged in a regular geometrical manner over the wafer 100, but their widths may also vary over the wafer 100.

Typical designs for the first and third regions 10, 20 are a stripe design (as shown in FIG 4) or a design, in which each first region 10 is surrounded by a third region 20 (as shown in FIG 5). In such a design, the first regions 10 may be in examplary embodiments of a square, rectangular or circular shape.

The second and/or fourth regions 12, 22 have in another preferred embodiment also a square, rectangular, cross or circular shape. FIG 6 shows such second and fourth regions 12, 22 with a square shape, whereas FIG 7 shows second and fourth regions 12, 22 with a circular shape. In these figures, each second region 12 is isolated from a fourth region 22 by intermediate lying first and/or third regions 10, 20. Alternatively, at least one second region 12 may also be attached to a fourth region 22. In the figures 6 to 8, the first and third regions 10, 20 are only indicated by hatching of the area designated with 10, 20 for clarity reasons, but the hatched area is meant to be an area of alternating first and third regions 10, 20 as e.g. shown in fig. 4 and 5.

As also shown in Fig. 3, in another embodiment the RC-IGBT 10 may further comprise an n type seventh layer 7, which is arranged between the base layer 101 and the first and second layer 1, 2 respectively, and which seventh layer 7 has a higher doping than the base layer 101.

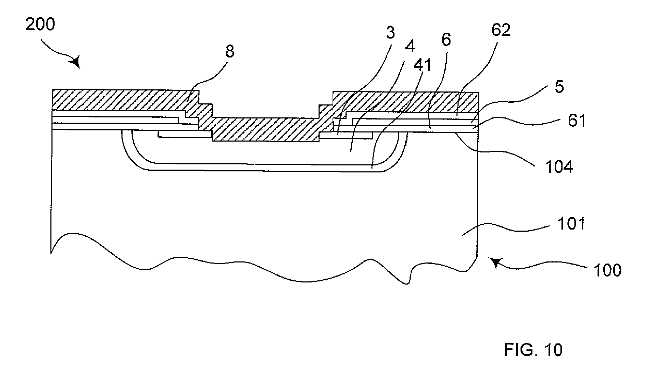

In another preferred embodiment shown in Fig. 10, an eighth n doped layer 41, formed as an enhancement layer, is arranged between the fourth layer 4 and the base layer 101 for having lower on-state losses. The eighth layer 41 separates the fourth layer 4 from the base layer 101 and it has higher doping than the base layer 101.

In another embodiment, the conductivity types of the layers are switched, i.e. all layers of the first conductivity type are p type (e.g. the base layer 101) and all layers of the second conductivity type are n type (e.g. the fourth layer 4).

The inventive reverse-conducting semiconductor device 200 can for example be used in a converter.

### Reference List

- 1: first layer
- 10: first region
- 11: width of first region
- 12: second region
- 13: width of second region
- 15: fifth region
- 16: width of fifth region
- 2: second layer
- 20: third region
- 21: width of third region
- 22: fourth region
- 23: width of fourth region
- 25: sixth region
- 26: width of sixth region
- 27: seventh region
- 28: width of seventh region
- 3: third layer
- 4: fourth layer
- 41: eighth layer
- 5, 5': fifth layer
- 6: sixth layer
- 61: first electrically insulating layer
- 62: second electrically insulating layer
- 7: seventh layer
- 8: first electrical contact
- 9: second electrical contact
- 100: wafer
- 101: base layer
- 102: base layer thickness
- 103: collector side
- 104: emitter side
- 200,200': RC-IGBT

## Claims

1. Reverse-conducting semiconductor device (200), which comprises a freewheeling diode and an insulated gate bipolar transistor on a common wafer (100), part of which wafer (100) forms a base layer (101), which has a base layer width (102), wherein
the insulated gate bipolar transistor comprises a collector side (103) and an emitter side (104) and the collector side (103) is arranged opposite of the emitter side (104) of the wafer (100), wherein
a first layer (1) of a first conductivity type and a second layer (2) of a second conductivity type are alternately arranged on the collector side (103),
**characterized in that**
the first layer (1) comprises at least one first and at least one second region (10, 12), wherein each first region (10) has a first region width (11) and each second region (12) has a second region width (13), **in that**
the second layer (2) comprises at least one third (20) and at least one fourth region (22), wherein each third region (20) has a third region width (21) and each fourth region (22) has a fourth region width (23),
wherein each third region width (21) is the equal to or larger than the base layer width (102), **in that**
each first region width (11) is smaller than the base layer width (102), **in that**
each fourth region width (23) is larger than each second region width (13), **in that**
each second region width is the equal to or larger than two times the base layer width (102), and **in that**
the total area of the fourth regions (22) is larger than the total area of the second regions (12).

2. Reverse-conducting semiconductor device (200) according to claim 1, **characterized in that** the widths (11, 21) of the at least one first and/or third regions (10, 20) vary over the wafer (100).

3. Reverse-conducting semiconductor device (200) according to claim 1, **characterized in that** the widths (11, 21) of at least one first and/or third regions (10, 20) is constant over the wafer (100).

4. Reverse-conducting semiconductor device (200) according to any of the claims 1 to 3, **characterized in that** the at least one first and third regions (10, 20) are arranged as stripes over the wafer (100).

5. Reverse-conducting semiconductor device (200) according to claim any of the claims 1 to 3, **characterized in that** each first region (10) is surrounded by a third region (20).

6. Reverse-conducting semiconductor device (200) according to claim 5, **characterized in that** the at least one first region (10) has a square, rectangular or circular shape.

7. Reverse-conducting semiconductor device (200) according to any of the claims 1 to 6, **characterized in that** each second region (12) is isolated from any fourth region (22) by at least one first and and/or third regions (10, 20).

8. Reverse-conducting semiconductor device (200) according to any of the claims 1 to 6, **characterized in that** at least one second region (12) is attached to a fourth region (22).

9. Reverse-conducting semiconductor device (200) according to any of the claims 1 to 8, **characterized in that** the at least one second and/or fourth regions (12, 22) has a square, rectangular, cross or circular shape.

10. Reverse-conducting semiconductor device (200) according to any of the claims 1 to 9, **characterized in that**
the total area of the third and fourth regions (20, 22) to total area of the wafer (100) is between 70 % up to 90 %.

11. Reverse-conducting semiconductor device (200) according to any of the claims 1 to 10, **characterized in that**
the total area of the first and second regions (10, 12) to total area of the wafer (100) is between 10 % up to 30 %.

12. Reverse-conducting semiconductor device (200) according to any of the claims 1 to 11, **characterized in that** the total area of the forth regions (22) to the total area of the wafer (100) is between 10 % to 30 %.

13. Converter with a reverse-conducting semiconductor device (10) according to any of the claims 1 to 12.
